Europäisches Patentamt

European Patent Office

Office européen des brevets

(19)

(11) Publication number: **0 195 232 B1**

## EUROPEAN PATENT SPECIFICATION

(12)

(45) Date of publication of patent specification: **11.12.91**

(51) Int. Cl.⁵: **G01L 1/18,** H01L 27/08, H01L 29/84

(21) Application number: **86101679.8**

(22) Date of filing: **10.02.86**

(54) Piezoresistive strain sensing device.

(30) Priority: **20.03.85 JP 54473/85**
**20.03.85 JP 54474/85**

(43) Date of publication of application:
**24.09.86 Bulletin 86/39**

(45) Publication of the grant of the patent:
**11.12.91 Bulletin 91/50**

(84) Designated Contracting States:
**DE FR GB**

(56) References cited:
**EP-A- 0 146 709**        **WO-A-81/03086**
**US-A- 3 132 788**        **US-A- 3 277 698**
**US-A- 3 491 274**        **US-A- 3 537 319**
**US-A- 3 899 695**

**PATENT ABSTRACTS OF JAPAN vol. 5, no.
121 (E-68) (793) 5 August 1981; & JP-A-56
60066**

**PATENT ABSTRACTS OF JAPAN vol. 6, no.
18 (P-100) (896) 2 February 1982; & JP-A-56
140229**

**PATENT ABSTRACTS OF JAPAN vol. 6, no.**

**182 (E-131) (1060) 18 September 1982; & JP-
A-57 95673**

**PHYSICAL REVIEW vol. 94, no. 1, 1 April 1954,
pages 42-49; C.S. SMITH: "Piezoresistance
Effect in Germanium and Silicon"**

(73) Proprietor: **HITACHI, LTD.**
**6, Kanda Surugadai 4-chome**
**Chiyoda-ku, Tokyo 100(JP)**

(72) Inventor: **Miura, Hideo**
**3602, Shimoinayoshi Chiyoda-mura**
**Niihari-gun Ibaraki-ken(JP)**
Inventor: **Sakamoto, Tatsuji**
**1-124, Tagu Ushiku-machi**
**Inashiki-gun Ibaraki-ken(JP)**
Inventor: **Nishimura, Asao**
**4-82, Sakae-machi Ushiku-machi**
**Inashiki-gun Ibaraki-ken(JP)**

(74) Representative: **Patentanwälte Beetz sen. -
Beetz jun. Timpe - Siegfried - Schmitt-
Fumian**
**Steinsdorfstrasse 10**
**W-8000 München 22(DE)**

## Description

BACKGROUND OF THE INVENTION:

FIELD OF THE INVENTION:

The present invention relates to a piezoresistive strain sensing device in which diffused resistors are formed in a semiconductor single-crystal substrate. More particularly, it relates to a piezoresistive strain sensing device which is well suited to sensitively and precisely detect a stress field acting on an IC chip within a semiconductor package.

DESCRIPTION OF THE PRIOR ART:

As a device wherein a mechanical stress resulting from the application of a strain is converted into an electric signal by utilizing the piezoresistance effect of a semiconductor, there has heretofore been, for example, a semiconductor strain sensor as disclosed in the official gazette of Japanese Patent Application Laid-open No. 56-140229. In this device, a bridge circuit is formed by diffused resistors on a diaphragm of silicon, and a strain is measured by detecting the fractional change in resistivity based on the deformation of the diaphragm attendant upon a surface strain. There has also been made the trial in which a diffused resistor is formed on a silicon substrate, and the substrate is buried in a resin as sensing means, thereby to detect a two-dimensional stress field acting within a surface formed with the diffused resistor. In either case, however, the detection on a specified stress component is aimed at, and the use has been limited. A three-dimensional stress field exists in a general structure, and mechanical strain - electricity transducers including the prior-art semiconductor strain sensor have had the problem that the three-dimensional stress field cannot be separately detected.

US-A-3 277 698 describes a piezoresistive strain sensing device comprising a semiconductor single-crystal substrate and a diffused resistance gauge constructed of a p-type diffused resistor and a n-type diffused resistor which are formed in said substrate, wherein the major axes of the crystal plane of the device are ⟨111⟩ and ⟨100⟩, which implies that at least one of the indices of the plane is zero, and wherein two p-type resistors and two n-type resistors may be diffused in the single crystal substrate parallel to each other, constructing the resistance gauge.

WO-A-8103086 discloses, in connection with a silicon pressure sensor comprising only one diffused resistor, that variations in the orientation of the crystal plane and in the directions of the resistor of the values claimed are possible and that said resistor may be rectangular and have electrode terminals provided on the four rectangle sides.

### SUMMARY OF THE INVENTION

An object of the present invention is to provide a piezoresistive strain sensing device which sensitively and precisely detects a stress field acting in an observation surface.

Said object is achieved according to the present invention by a piezoresistive strain sensing device comprising a semiconductor single-crystal substrate which has such a crystal plane that at least one of crystal plane indices h, k and $\ell$ becomes zero (but that all of the indices h, k and $\ell$ do not simultaneously become zero), and p-type diffused resistors and n-type diffused resistors which are formed in said substrate, a diffused resistance gauge being constructed of respective resistor gauges of said p-type diffused resistors and said n-type diffused resistors, characterized in that the crystal plane indices of said semiconductor single-crystal substrate are (100), that said each p-type diffused resistor is arranged in a direction of a crystal axis ⟨011⟩, whilst said each n-type diffused resistor is arranged in a direction of a crystal axis ⟨001⟩, or vice versa, and that a common electrode terminal is held in communication with ends of the respective diffused resistors on one side, whilst independent electrode terminals are held in communication with ends of said respective diffused resistors on the other side.

Said object is also achieved, according to the present invention, by a piezoresistive strain sensing device comprising a semiconductor single-crystal substrate and p-type diffused resistors and n-type diffused resistors which are formed in said substrate, a diffused resistance gauge being constructed of respective resistor gauges of said p-type diffused resistors and said n-type diffused resistors, characterized in that the crystal plane indices of said semiconductor single-crystal substrate are (111), that three p-type diffused resistors are arranged at angular intervals of 45°, whilst three n-type diffused resistors are arranged at angular intervals of 45°, and that a common electrode terminal is held in communication with

2

ends of said three p-type diffused resistors on one side and independent electrode terminals are held in communication with ends thereof on the other side, whilst a common electrode terminal is held in communication with ends of said three n-type diffused resistors on one side and independent electrode terminals are held in communication with ends thereof on the other side.

In general, the piezoresistance effect in a semiconductor such as silicon is expressed as:

$$\delta \rho_{ij} = \sum_{k\ell} \pi_{ijk\ell} X_{k\ell} \qquad \ldots(1)$$

using a resistivity $\rho$ and a stress tensor X each of which is denoted by a tensor of the second order, and a tensor $\pi$ of the fourth order.

Since, in general, the tensor of the second order such as $\rho$ or X is given by a six-component vector notation, the tensor $\pi$ of the fourth order is expressed as a 6 x 6-element tensor. To the end of studying a three-dimensional stress field, when the directions of three right-angled axes are respectively set as x-, y- and z-directions and xx, yy, zz, yz, zx and xy are respectively rewritten as 1 - 6, Eq. (1) can be expressed as:

$$\delta \rho_\mu = \sum_{\lambda=1}^{6} \pi_{\mu\lambda} X_\lambda \qquad \ldots(2)$$

Here, $\pi\mu\lambda$ is called the "components of the piezoresistance tensor" and consists, in general, of 21 components. The number of the independent components decreases in a crystal of good symmetry, and it becomes 3 in a crystal having the cubic symmetry such as silicon or germanium.

When a diffused resistor is formed on any desired single-crystal substrate and the fractional change of the resistivity thereof is detected, there are, in general, 6 stress components contributive to the fractional change of the resistivity. Since, however, the fractional change of the resistivity is detected in a two-dimensional plane formed with the diffused resistor, only 3 resistance components can be independently measured on the plane. Accordingly, when one diffused resistor is used, it is impossible in principle to separately detect the stress components.

Therefore, a diffused strain gauge for detection needs to be constructed of a plurality of independent diffused resistors. In order to detect six independent resistance components on the same plane, at least two sorts of diffused resistors must be formed. The piezoresistance coefficients which are sensitivities to a stress differ greatly, depending upon the kinds of dopants. Accordingly, diffused resistors of the p-type and n-type are formed on a semiconductor substrate having a crystal plane, all of the crystal plane indices (h, k, ℓ) of which have values different from zero, and three independent resistance components are detected in each of the regions, whereby six independent resistance components on the same plane become detectible. Thus, the three-dimensional stress field acting in the observation plane can be uniquely determined.

Next, when the (100) plane is assumed the xy-plane and a conventional crystal axis ⟨001⟩ is brought into agreement with the x-axis, the piezoresistance effect which is observed within the plane is expressed as:

$$\left.\begin{array}{l}
\delta \rho_{xx} = \pi_{11} \sigma_x + \pi_{12} \sigma_y + \pi_{12} \sigma_z \\[4pt]
\delta \rho_{yy} = \pi_{12} \sigma_x + \pi_{11} \sigma_y + \pi_{12} \sigma_z \\[4pt]
\delta \rho_{xy} = \pi_{44} \sigma_{xy}
\end{array}\right\} \qquad \ldots(3)$$

where $\sigma_{x \sim z}$ denotes a normal stress component, $\pi_{\alpha\beta}$ a proportion constant, and $\tau_{xy}$ a shear stress component within the xy-plane.

Accordingly, stress components which affect the fractional changes of resistivity are four components, and the resistivity changes which are independently detectible are of three components, so that the stress field acting in the crystal plane cannot be uniquely determined. Since, however, the piezoresistance coefficients $\pi_{\alpha\beta}$ differ depending upon the kinds of dopants used for diffused resistors, the resistivity changes can be independently detected in the respective diffused regions of the p-type diffused resistor and the n-type diffused resistor which are arranged in proximity to each other, and hence, the resistivity changes of six components can be independently measured in both the regions. Accordingly, p-type and n-type diffused resistors are formed in the surface layer of a semiconductor substrate having a crystal plane orientation as to which at least one of crystal plane indices (h, k, $\ell$) becomes zero (however, all the indices h, k and $\ell$ do not become zero simultaneously), whereby four resistor gauges capable of independent measurements can be provided, and the four stress components influential on the resistivity changes can be uniquely determined. Further, it is readily derived from Eq. (1) or Eq. (2) that the same holds within a crystal plane in which the direction of the crystal axis $\langle 100 \rangle$ is included.

BRIEF DESCRIPTION OF THE DRAWINGS:

Fig. 1 is a plan view of a first embodiment of a piezoresistive strain sensing device according to the present invention;

Fig. 2 is a sectional view taken along line II - II' in Fig. 1;

Fig. 3 is a plan view of a second embodiment of the piezoresistive strain sensing device of the present invention;

Fig. 4 is a sectional view of a third embodiment of the piezoresistive strain sensing device of the present invention;

Fig. 5 is a plan view of a fourth embodiment of the piezoresistive strain sensing device of the present invention; and

Fig. 6 is a sectional view taken along line VI - VI' in Fig. 5.

DETAILED DESCRIPTION OF THE PREFERRED EMBODIMENTS:

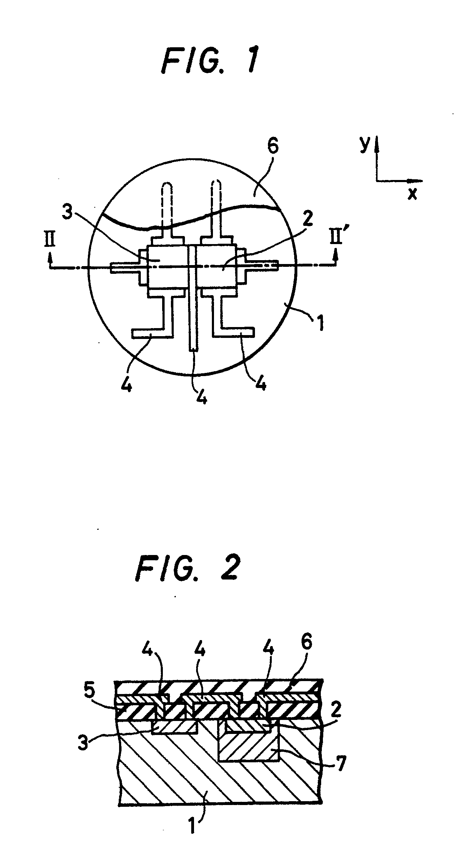

Now, one embodiment of a piezoresistive strain sensing device according to the present invention will be described with reference to Figs. 1 and 2. In this embodiment, a strain sensor is constructed by making a p-type diffused resistor 3 and an n-type diffused resistor 2 on an n-type silicon (100) substrate 1 by the use of the CMOS process. Fig. 1 shows a plan view, while Fig. 2 shows a sectional view taken along line II - II' in Fig. 1 and illustrates the formed states of the diffused resistors. The p-type diffused resistor 3 and the n-type diffused resistor 2, which is buried in a p-type diffused resistor layer 7, are respectively made in the shape of rectangles in proximity to each other, and electrode terminals 4 are provided on the four sides of each rectangle. The electrode terminals 4 are isolated by an $SiO_2$ film 5, and the whole surface is covered with a passivation film 6. Regarding the directions of the sides of the rectangles, the direction along the line II - II' is set to be the x-direction, and the direction orthogonal thereto in the same plane is set to be the y-direction. A method of measuring the changes of a resistivity in each diffused resistor will be described. Current is caused to flow across the two electrodes opposing in the x-direction, and the potential difference across both the electrodes is measured, whereby $\delta\rho_{xx}$ in the equation (3) mentioned before is measured. A similar method is performed across the two electrodes opposing in the y-direction, whereby $\delta\rho_{yy}$ in Eq. (3) is measured. In addition, current is caused to flow across the electrodes opposing in the x-direction, and the potential difference across the electrodes opposing in the y-direction is measured, whereby $\delta\rho_{xy}$ in Eq. (3) is determined. Thus, the resistivity changes of the three independent components can be measured with the single diffused resistor. When $\delta\rho_{xy}$ is measured with either of the p-type and n-type diffused resistors, and besides, three of $\delta\rho_{nxx}$, $\delta\rho_{nyy}$, $\delta\rho_{pxx}$ and $\delta\rho_{pyy}$ are measured, four independent resistivity changes can be measured within the single crystal plane.

According to the present embodiment, four independent resistivity changes can be measured within the (100) crystal plane of silicon, and this brings forth the effect that stresses $\sigma_x$ and $\sigma_y$ in the directions of two axes, a shear stress $\tau_{xy}$ and a stress $\sigma_z$ perpendicular to the plane, which act on the crystal plane, can be uniquely determined.

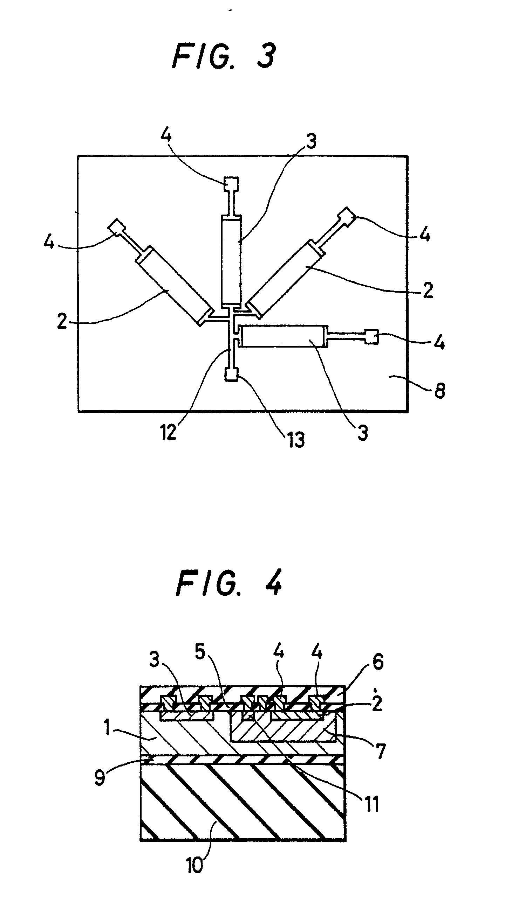

Next, a second embodiment of the piezoresistive strain sensing device of the present invention will be described with reference to Fig. 3. This figure shows a plan view of a thin-film stress/strain sensor to which the present invention is applied. A single-crystal thin film of silicon having the (100) plane is formed on a film substrate (of, for example, PIQ) 8, and p-type diffused resistors 3 and n-type diffused resistors 2 are formed as shown in the figure. The ends of these diffused resistors 2 and 3 on one side are connected by a common pattern 12, and are held in communication with a common electrode terminal 13. The single-crystal thin film is produced by a thin-film manufacturing process such as vacuum evaporation, CVD (Chemical Vapored Deposition), sputtering evaporation or epitaxial growth. Here, when the p-type diffused resistors 3 are arranged along the conventional crystal axis ⟨011⟩ and the n-type diffused resistors 2 along ⟨001⟩, the resistivity changes of the respective resistors are expressed as:

$$
\begin{aligned}
\delta\rho_{(p)} &= \frac{1}{2}(\pi_{11} + \pi_{12})(\sigma'_x + \sigma'_y) \\
&\quad + \pi_{12}\,\sigma'_z \pm (\pi_{11} - \pi_{12})\,\tau_{xy} \\
\delta\rho_{(n)} &= \frac{1}{2}(\pi_{11} + \pi_{12} \pm \pi_{44})\,\sigma'_x \\
&\quad + \frac{1}{2}(\pi_{11} + \pi_{12} \pm \pi_{44})\,\sigma'_y + \pi_{12}\,\sigma'_z
\end{aligned} \quad \cdots (4)
$$

In Eq. (4), $\pi_{ij}$ denotes a piezoresistance coefficient in the case where the direction of the ⟨001⟩ crystal axis is brought into agreement with the directions of the right-angled three axes. Since the resistivity changes in the p-type diffused resistors 3 and the n-type diffused resistors 2 are independently measured, the four components of stresses ($\sigma_x$, $\sigma_y$, $\sigma_z$, $\sigma_{xy}$) are uniquely determined. From this fact, it is apparent that the thin-film stress/strain sensor for semiconductors can be constructed.

Next, a third embodiment of the piezoresistive strain sensing device of the present invention will be described with reference to Fig. 4. This figure is a sectional view in the case where a semiconductor pressure sensor is constructed. In the surface layer of an n-type silicon (100) single-crystal substrate 1 in the shape of a disc, a p-type diffused resistor 3 and an n-type diffused resistor 2 are formed to construct a gauge. The single-crystal substrate 1 is bonded to a glass substratum 10 by a low-melting glass 9. Further, an n-type diffused resistor 11 is formed in a p-type diffused layer 7, to construct a p/n-junction, whereupon the temperature of the gauge is detected. Thus, a temperature compensation circuit is formed, and measurements in a wide temperature range become possible. Moreover, since the silicon substrate may be in the shape of the disc, a high degree of etching technique as in the case of making a diaphragm is dispensed with, to bring forth the effect that the available percentage in production is enhanced.

According to the embodiments thus far described, since four resistivity changes within the (100) crystal plane of a semiconductor can be measured, it is possible to realize a piezoresistive strain sensing device which can uniquely determine the four stress components acting on the (100) crystal plane; stress components in the directions of right-angled three axes, two of them being contained in the plane, and a shear stress acting within the plane.

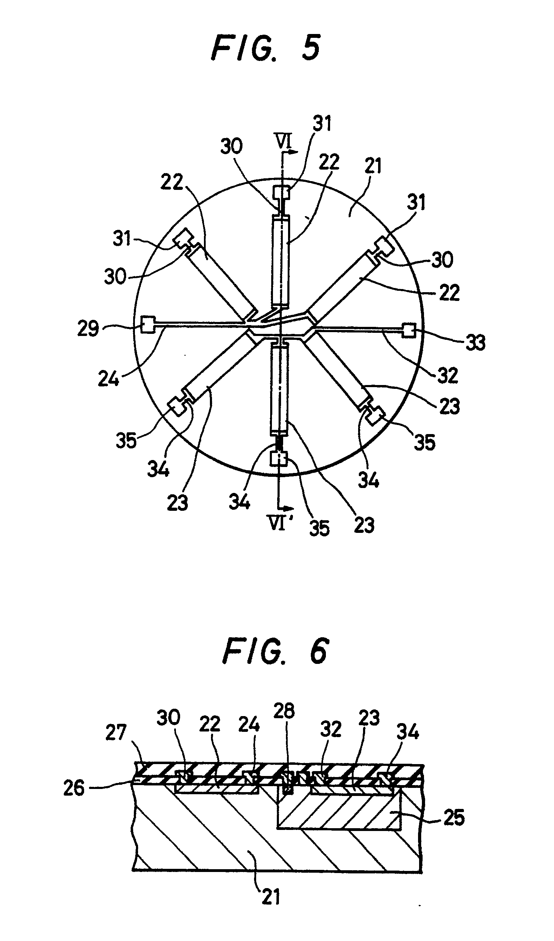

Next, a fourth embodiment of the piezoresistive strain sensing device of the present invention will be described with reference to Figs. 5 and 6. This embodiment is a stress sensor which is fabricated using an n-type silicon (111) single-crystal disc 21 as a substrate Fig. 5 is a plan view, while Fig. 6 is a schematic sectional view taken along line VI - VI' in Fig. 5. Six diffused resistors 22 and 23 formed on the substrate 21 consist of three p-type diffused layers 22 and three n-type diffused layers 23, and the ends of the respective layers 22 or 23 on one side are connected by a single aluminium pattern 24 or 32. It is assumed that the individual diffused resistors 22 or 23 be formed at angular intervals of 45°. It is also assumed that the direction of the line VI - VI' agree with the direction of the ⟨112⟩ crystal axis. The ends of the three p-type diffused resistors 22 on one side are connected to a common electrode terminal 29 through the single common A1 pattern 24, whereas the ends thereof on the other side are connected to separate electrode terminals 31 through separate A1 patterns 30. Likewise, the ends of the three n-type diffused resistors 23 on one side are connected to a common electrode terminal 33 through the single common A1 pattern 32, whereas the ends thereof on the other side are connected to separate electrode terminals 35 through separate A1 patterns 34. The n-type diffused resistors 23 are formed in a p-type diffused layer 25. In addition, the A1 patterns 24 etc. are isolated by an $SiO_2$ insulator film 26, and the whole surface is covered with a passivation film 27. The p-type diffused layer 25 is formed with an n-type diffused resistor 28, to simultaneously make a p/n-junction for temperature compensation. Now, the operation of this sensor will be described.

Right-angled 3 axes are given with the x-direction being the direction of the line VI - VI', the y-direction being a direction orthogonal thereto within the plane and the z-direction being a direction perpendicular to the plane, and stresses in the axial directions and shear stresses within respective planes are respectively denoted by $\sigma$ and $\tau$. In Fig. 5, a resistivity on the line VI - VI' is denoted by $\rho_2$, that on the left side thereof is denoted by $\rho_1$, and that on the right side thereof is denoted by $\rho_3$. Then, the corresponding resistivity changes are expressed as:

$$
\left.
\begin{aligned}
\delta\rho_1 &= \pi_\alpha (\sigma'_x + \sigma'_y) + \pi_\beta \sigma'_z + \pi_\gamma \tau_{xy} + \pi_\eta \tau_{yz} \\[2mm]
\delta\rho_2 &= \pi_\lambda \sigma'_x + \pi_\mu \sigma'_y + \pi_\nu \sigma'_z - \pi_\eta \tau_{zx} \\[2mm]
\delta\rho_3 &= \pi_\alpha (\sigma'_x + \sigma'_y) + \pi_\beta \sigma'_z - \pi_\gamma \tau_{xy} + \pi_\eta \tau_{yz}
\end{aligned}
\right\} \quad \ldots(5)
$$

As the diffused resistors of the p-type diffused layers 22 and those of the n-type diffused layers 23, the values of the piezoresistance coefficients $\pi_i$ (i = $\alpha$, $\beta$, ...) are different, so that six sorts of independent resistivity changes can be measured. Since stress components contributive to the respective resistivity changes are of six sorts, the respective components of the stress tensor or the three-dimensional stress field are/is separately detected by solving the matrix of Eq. (2).

The embodiment thus far described brings forth the effect that a sensor for detecting a three-dimensional stress field can be realized, and the effect that measurements at temperatures in a wide range are permitted by utilizing a p/n-junction for temperature compensation.

In the foregoing embodiment, the individual diffused resistors 22 or 23 are formed at the angular intervals of 45°. This takes it into consideration that, on the (111) crystal plane, the lengthwise directions of the resistor layers are brought into agreement with the ⟨112⟩ crystal axis and the ⟨110⟩ crystal axis, while one resistor layer is arranged in the direction of 45° between them. In principle, however, the directions of the arrangement of the resistor layers may be as desired (except a case where two or more resistors become parallel among the same kind of diffused resistor layers).

Although the three diffused resistors are arranged in each kind of diffused layers, the number of the arrangement in each kind of diffused layers may well be four or more. Since the number of stress components acting independently is six, the stress components are uniquely determined when there are at least three diffused resistors in each kind of layers, namely, at least six resistors in total. In the case of forming at least four diffused resistors in the same kind of diffused layers, at least three of them may extend in crystal orientations differing from one another.

In an actual measurement, changes in the resistivities of the diffused resistors are respectively detected.

In each of the foregoing embodiments, the semiconductor single-crystal substrate may well be replaced with a single-crystal thin film produced by a thin-film manufacturing process such as vacuum evaporation, CVD, sputtering or epitaxial growth.

According to each embodiment described above, six sorts of independent resistivity changes caused by the piezoresistance effect can be detected on an identical semiconductor single-crystal substrate and hence, a stress sensor for determining a three-dimensional stress field can be realized.

## Claims

1. A piezoresistive strain sensing device comprising a semiconductor single-crystal substrate (21) which has such a crystal plane that at least one of crystal plane indices h, k and ℓ becomes zero (but that all of the indices h, k and ℓ do not simultaneously become zero), and p-type diffused resistors (22) and n-type diffused resistors (23) which are formed in said substrate (21), a diffused resistance gauge being constructed of respective resistor gauges of said p-type diffused resistors (22) and said n-type diffused resistors (23),

   **characterized** in that

   the crystal plane indices of said semiconductor single-crystal substrate (21) are (100), that said each p-type diffused resistor (22) is arranged in a direction of a crystal axis ⟨011⟩, whilst said each n-type

diffused resistor (23) is arranged in a direction of a crystal axis (001), or vice versa, and that a common electrode terminal (29; 33) is held in communication with ends of the respective diffused resistors on one side, whilst independent electrode terminals (31; 35) are held in communication with ends of said respective diffused resistors on the other side.

2. A piezoresistive strain sensing device according to claim 1, further comprising a p-n junction for temperature compensation which is formed near said diffused resistance gauge formed in said semiconductor single-crystal substrate (21).

3. A piezoresistive strain sensing device according to claim 1 or 2, wherein said semiconductor single-crystal substrate (21) is a single-crystal thin film which is prepared by a thin-film manufacturing process.

4. A piezoresistive strain sensing device according to claim 1, wherein said p-type diffused resistors (22) and said n-type diffused resistors (23) are formed in the shape of rectangles, electrode terminals being provided on four sides of said each rectangle.

5. A piezoresistive strain sensing device comprising a semiconductor single-crystal substrate (21) and p-type diffused resistors (22) and n-type diffused resistors (23) which are formed in said substrate (21), a diffused resistance gauge being constructed of respective resistor gauges of said p-type diffused resistors (22) and said n-type diffused resistors (23),
characterized in that
the crystal plane indices of said semiconductor single-crystal substrate (21) are (111), that three p-type diffused resistors (22) are arranged at angular intervals of 45°, whilst three n-type diffused resistors (23) are arranged at angular intervals of 45°, and that a common electrode terminal (29) is held in communication with ends of said three p-type diffused resistors (22) on one side and independent electrode terminals (31) are held in communication with ends thereof on the other side, whilst a common electrode terminal (33) is held in communication with ends of said three n-type diffused resistors (23) on one side and independent electrode terminals (35) are held in communication with ends thereof on the other side.

6. A piezoresistive strain sensing device according to claim 5, further comprising a p-n junction for temperature compensation which is formed near said diffused resistance gauge formed in said semiconductor single-crystal substrate (21).

7. A piezoresistive strain sensing device according to claim 5 or claim 6, wherein said semiconductor single-crystal substrate (21) is a single-crystal thin film which is prepared by a thin-film manufacturing process.

**Revendications**

1. Dispositif piézorésistif de détection de contraintes comprenant un substrat semiconducteur monocristallin (21) qui possède un plan cristallin tel qu'au moins l'un des indices h, k et l du plan cristallin s'annule (mais que les indices h, k et l ne deviennent pas tous simultanément $\overline{nuls}$), et des résistances diffusées de type p (22) et des résistances diffusées de type n (23), qui sont formées dans ledit substrat (21), une jauge à résistances diffusées étant constituée par des jauges à résistances respectives desdites résistances diffusées de type p (22) et desdites résistances diffusées de type n (23),
caractérisé en ce que
les indices du plan cristallin dudit substrat semiconducteur monocristallin (21) sont (100), que chaque résistance diffusée de type p (22) est disposée dans une direction de l'axe cristallin (011), tandis que chacune desdites résistances diffusées de type n (23) est disposée dans une direction d'un axe cristallin (001) ou vice versa et qu'une borne d'électrode commune (29;33) est maintenue en communication avec des extrémités de résistances diffusées respectives d'un côté, tandis que des bornes d'électrodes indépendantes (31;35) sont maintenues en communication avec des extrémités desdites résistances diffusées respectives de l'autre côté.

2. Dispositif piézorésistif de détection de contraintes selon la revendication 1, comprenant en outre une jonction p-n pour une compensation de température, qui est formée à proximité de ladite jauge à résistances diffusées formée dans ledit substrat semiconducteur monocristallin (21).

3. Dispositif piézorésistif de détection de contraintes selon la revendication 1 ou 2, dans lequel ledit substrat semiconducteur monocristallin (21) est une pellicule mince monocristalline qui est préparée au moyen d'un procédé de fabrication d'une pellicule mince.

4. Dispositif piézorésistif de détection de contraintes selon la revendication 1, dans lequel lesdites résistances diffusées de type p (22) et lesdites résistances diffusées de type n (23) sont réalisées avec la forme de rectangles, des bornes d'électrodes étant prévues sur les quatre côtés de chacun desdits rectangles.

5. Dispositif piézorésistif de détection de contraintes comprenant un substrat semiconducteur monocristallin (21) et des résistances diffusées de type p (22) et des résistances diffusées de type n (23), qui sont formées dans ledit substrat (21), une jauge à résistances diffusées étant constituée par des jauges respectives formées desdites résistances diffusées de type p (22) et desdites résistances diffusées de type n (23),
caractérisé en ce que
les indices du plan cristallin dudit substrat semiconducteur monocristallin (21) sont (111), que trois résistances diffusées de type p (22) sont disposées à des intervalles angulaires de 45°, tandis que trois résistances diffusées de type n (23) sont disposées à des intervalles angulaires de 45°, et qu'une borne d'électrode commune (29) est maintenue en communication avec des extrémités desdites trois résistances diffusées de type p (22) d'un côté et que des bornes d'électrodes indépendantes (31) sont maintenues en communication avec des extrémités de ces résistances de l'autre côté, tandis qu'une borne d'électrode commune (33) est maintenue en communication avec des extrémités desdites trois résistances diffusées de type n (23) d'un côté et que des bornes d'électrodes (35) sont maintenues en communication avec des extrémités de ces résistances de l'autre côté.

6. Dispositif piézorésistif de détection de contraintes selon la revendication 5, comprenant en outre une jonction p-n pour une compensation de température, qui est formée à proximité de ladite jauge à résistances diffusées formée dans ledit substrat semiconducteur monocristallin (21).

7. Dispositif piézorésistif de détection de contraintes selon la revendication 5 ou 6, dans lequel ledit substrat semiconducteur monocristallin (21) est une pellicule monocristalline mince qui est préparée au moyen d'un procédé de fabrication de pellicule mince.

**Patentansprüche**

1. Piezoresistive Belastungsfühleranordnung mit einem Halbleitereinkristallsubstrat (21), das eine solche Kristallebene hat, daß wenigstens einer der Kristallebenenindices h, k und l null wird (daß jedoch nicht alle der Indices h, k und l gleichzeitig null werden), und mit p-Typ-diffundierten Widerständen (22) und n-Typ-diffundierten Widerständen (23), die im Substrat (21) gebildet sind, wobei eine diffundierte Widerstandsmeßstrecke aus den jeweiligen Widerstandsmeßstrecken der p-Typ-diffundierten Widerstände (22) und der n-Typ-diffundierten Widerstände (23) gebildet wird,

**dadurch gekennzeichnet,**

daß die Kristallebenenindices des Halbleitereinkristallsubstrats (21) (100) sind, daß jeder p-Typ-diffundierte Widerstand (22) in einer Richtung einer Kristallachse ⟨011⟩ angeordnet ist, während jeder n-Typ-diffundierte Widerstand (23) in einer Richtung einer Kristallachse ⟨001⟩ angeordnet ist, oder umgekehrt, und daß ein gemeinsamer Elektrodenanschluß (29; 33) in Verbindung mit Enden der jeweiligen diffundierten Widerstände an einer Seite gehalten wird, während unabhängige Elektrodenanschlüsse (31; 35) in Verbindung mit Enden der jeweiligen diffundierten Widerstände an der anderen Seite gehalten werden.

2. Piezoresistive Belastungsfühleranordnung nach Anspruch 1, die weiter einen p-n-Übergang zur Temperaturkompensation aufweist, der nahe der im Halbleitereinkristallsubstrat (21) gebildeten diffundierten Widerstandsmeßstrecke gebildet ist.

3. Piezoresistive Belastungsfühleranordnung nach Anspruch 1 oder 2, wobei das Halbleitereinkristallsubstrat (21) ein Einkristalldünnfilm ist, der durch ein Dünnfilmherstellverfahren hergestellt wird.

4. Piezoresistive Belastungsfühleranordnung nach Anspruch 1, wobei die p-Typ-diffundierten Widerstände (22) und die n-Typ-diffundierten Widerstände (23) in der Form von Rechtecken gebildet sind und Elektrodenanschlüsse an vier Seiten jedes Rechtecks vorgesehen sind.

5. Piezoresistive Belastungsfühleranordnung mit einem Halbleitereinkristallsubstrat (21) und p-Typ-diffundierten Widerständen (22) und n-Typ-diffundierten Widerständen (23), die im Substrat (21) gebildet sind, wobei eine diffundierte Widerstandsmeßstrecke aus den jeweiligen Widerstandsmeßstrecken der p-Typ-diffundierten Widerstände (22) und der n-Typ-diffundierten Widerstände (23) gebildet wird,

dadurch gekennzeichnet,

daß die Kristallebenenindices des Halbleitereinkristallsubstrats (21) (111) sind, daß drei p-Typ-diffundierte Widerstände (22) in Winkelabständen von 45° angeordnet sind, während drei n-Typ-diffundierte Widerstände (23) in Winkelabständen von 45° angeordnet sind, und daß ein gemeinsamer Elektrodenanschluß (29) in Verbindung mit Enden der drei p-Typ-diffundierten Widerstände (22) an einer Seite gehalten wird und unabhängige Elektrodenanschlüsse (31) in Verbindung mit deren Enden an der anderen Seite gehalten werden, während ein gemeinsamer Elektrodenanschluß (33) in Verbindung mit Enden der drei n-Typ-diffundierten Widerstände (23) an einer Seite gehalten wird und unabhängige Elektrodenanschlüsse (35) in Verbindung mit deren Enden an der anderen Seite gehalten werden.

6. Piezoresistive Belastungsfühleranordnung nach Anspruch 5, die weiter einen p-n-Übergang zur Temperaturkompensation aufweist, der nahe der im Halbleitereinkristallsubstrat (21) gebildeten diffundierten Widerstandsmeßstrecke gebildet ist.

7. Piezoresistive Belastungsfühleranordnung nach Anspruch 5 oder Anspruch 6, wobei das Halbleitereinkristallsubstrat (21) ein Einkristalldünnfilm ist, der durch ein Dünnfilmherstellverfahren hergestellt wird.

# FIG. 1

# FIG. 2

## FIG. 3

## FIG. 4

# FIG. 5

# FIG. 6